Europäisches Patentamt

European Patent Office

Office européen des brevets

(19)

(11) Publication number : **0 488 600 A1**

(12)

# EUROPEAN PATENT APPLICATION

(21) Application number : **91310781.9**

(22) Date of filing : **22.11.91**

(51) Int. Cl.$^5$ : **G08B 25/12, H05K 5/02**

(30) Priority : **24.11.90 GB 9025591**

(43) Date of publication of application :
**03.06.92 Bulletin 92/23**

(84) Designated Contracting States :
**DE FR GB**

(71) Applicant : **KAC ALARM COMPANY LIMITED**
**Tything Road West, Arden Forest Industrial**
**Estate**
**Alcester, Warwickshire B49 6EP (GB)**

(72) Inventor : **Walden Alan K.**
**Pyrcroft,21 Lincoln Drive**
**Pyrford Woking Surrey GU 22 8 RN (GB)**
Inventor : **Wallace Gerard P.**
**3 Dunley Croft**
**Monkspath Solihull West Midlands B90 4UA**
**(GB)**

(74) Representative : **Lewis, Samuel Hewitt**
**FORRESTER & BOEHMERT**
**Franz-Joseph-Strasse 38**
**W-8000 München 40 (DE)**

(54) **Terminal box and call point.**

(57) A terminal box (10) for a call point is installed in a building and connected with a remote monitoring position by permanent wiring. Terminals (15, 16) are bridged by a link (41). The call point is installed subsequently on the terminal box, the link being discarded.

FIG 1

EP 0 488 600 A1

The present invention relates to a call point, by which we mean a structure comprising a switch or other electrical signalling device and a housing or cover in which the signalling device is supported. Fire alarm call points are common examples of call points. These generally have a frangible plate which normally maintains the signalling device in a first condition but permits the signalling device to assume a second condition, when broken. To this end, the signalling device generally includes a spring-loaded plunger which bears on the frangible plate.

A fire alarm call point is normally mounted on a terminal box by means of fasteners which are typically accessible only when the frangible plate has been removed from the call point. The signalling device is connected electrically with a remote station by means of wiring which extends from the remote station to the signalling device.

According to the present invention, there are provided a terminal box and a call point which are suitable for releasable mounting of the call point on the terminal box, wherein the terminal box includes at least one pair of electrical terminals and wherein the call point includes a signalling device, a connector and a pair of electrical conductors extending between the signalling device and the connector, the connector being adapted to cooperate with the terminals of the terminal box to establish a releasable, electrical connection between the signalling device and the terminals.

A terminal box and call point embodying the invention facilitate the installation of the terminal box and of wiring between the terminal box and a remote station before the call point is fitted to the terminal box. The call point may be fitted subsequently, secured to the terminal box by screws or other fasteners and connected electrically with the terminals of a terminal box by means of the connector.

The terminal box preferably further comprises a link which links the terminals electrically to each other, which is displaceable from the terminals and which, whilst linking the terminals, obstructs application of the connector to the terminals, whereby application of the connector to the terminals to connect the signalling device to the terminals can be achieved only by displacing the link from the terminals. With this arrangement, wiring which is installed with the terminal box but without the call point can be tested before the call point is fitted to the terminal box. Furthermore, if the link is displaced from the terminals, the connector is then fitted to the terminals and the connector is subsequently removed from the terminals, for example in the event of removal of the call point from the terminal box, removal of the connector will leave the terminals not connected electrically to each other and this condition can be detected at the remote station. The arrangement is preferably such that the link must be removed from the terminals, in order to admit the connector to the terminals. If removed from the terminal box the link will no longer be available to provide electrical connection between the terminals, in the event of removal of the connector.

Examples of call points and associated terminal boxes which, in combination, embody the present invention will now be described, with reference to the accompanying drawings, wherein:

FIGURE 1 shows a diagrammatic representation of a perspective view of a call point and terminal box,

FIGURE 2 is a diagrammatic representation of a perspective view of a second terminal box and

FIGURE 3 is a diagrammatic representation of a perspective view from the rear of a call point suitable for use with the terminal box of Figure 2.

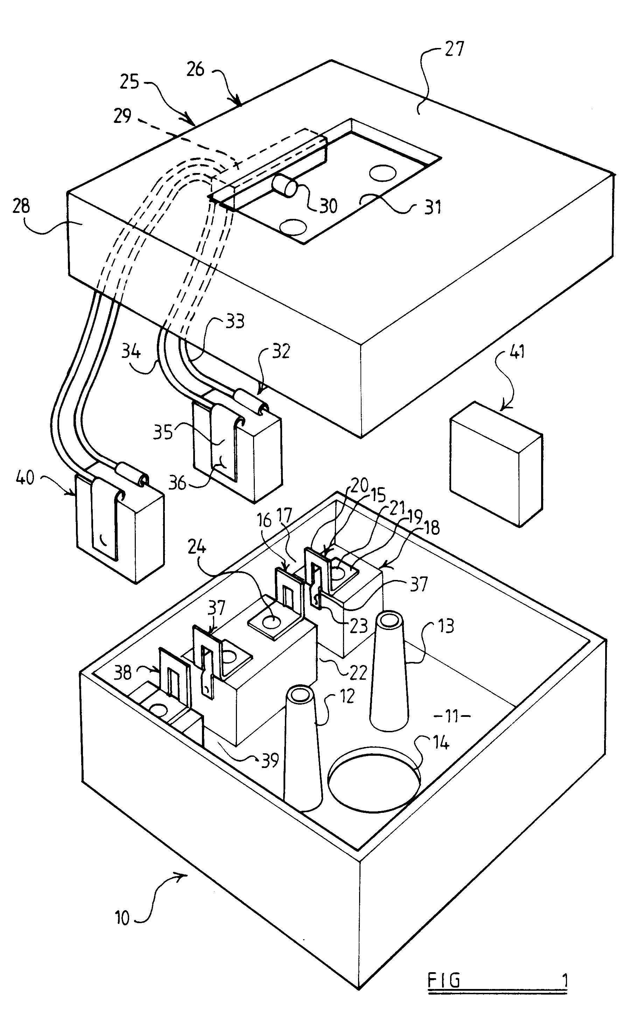

The terminal box shown at 10 in Figure 1 comprises a rectangular bottom wall 11 and four side walls around the periphery of the bottom wall. Inside the terminal box, there is a pair of pillars 12 and 13 for receiving fasteners, by means of which a call point can be attached to the terminal box. In the bottom wall 11, there is at least one opening 14 through which cables can enter the terminal box. These cables (not shown) are used to connect terminals of the terminal box with a remote control station and with further terminal boxes, in a known manner.

There is also disposed in the terminal box a first pair of electrical terminals 15, 16 which are spaced apart by a gap 17. As shown, the terminals are conveniently mounted on a seat 18 which lies between the bottom wall 11 and the open mouth of the terminal box.

The terminal 15 comprises first and second limbs 19 and 20 which are substantially at right angles to each other. The limb 19 lies in face-to-face contact with the seat 18 and has an aperture through which there extends a fixing screw 21 which is screwed into a bore formed in the seat. There is a slot 22 in the seat and a tail 23 of the terminal 15 extends from the limbs 19 and 20 into the slot 22 towards the bottom wall 11. The tail 23 may lie in face-to-face contact with a surface of the seat 18 which is perpendicular to the bottom wall 11.

The terminal 16 is of the same form as the terminal 15 and is mounted on the seat in a similar way with a tail of the terminal 16 (not shown) also extending into the slot 22 but at the opposite side of the slot from the tail 23. The screw 21 associated with the terminal 15 and the corresponding screw 24 associated with the terminal 16 may be used to secure to these terminals electrical conductors incorporated in the cable which extends to a remote station. Alternatively, further screws or other connecting devices may be provided for connecting the cable with the terminals 15 and 16.

The terminals 15 and 16 are conveniently formed from flat metal strip, the strip being pierced and bent to form the tails.

The call point 25 comprises a housing 26 with a top wall 27 similar in shape to the bottom wall 11 and peripheral walls around the periphery of the top wall 27, one of these being shown at 28. The underside of the housing 26 may be open so that the housing forms a lid to the terminal box 10. The housing 26 is secured to the terminal box by means of screws which enter threaded bores formed in the pillars 12 and 13.

In the call point housing 26, there is mounted signalling means in the form of a micro-switch 29 having a spring-loaded plunger 30 which can project from the micro-switch. The plunger is normally held in a depressed position by means of a plate 31 of glass or other frangible material. The plate is mounted in the housing 26 and is accessible through a window defined by the wall 27. If the plate is broken, it releases the plunger 30 which is moved into projecting position and this movement is signalled electrically by the micro-switch 29. The call point 25 may be constructed and arranged in a known manner.

The micro-switch 29 is connected electrically with the terminals 15 and 16 by means of a connector 32 and a pair of flexible leads 33 and 34. The connector 32 has the form of a block and a size such that the block can be fitted in the gap 17 to engage both of the terminals concurrently. At opposite faces of the connector, there are provided electrically conductive contact elements, one of which is shown at 35, for engaging with respective ones of the terminals. The contact elements preferably incorporate integral terminations for the leads 33 and 34 respectively.

The connector 32 and the terminals 15 and 16 are provided with respective retaining formations for releasably retaining the connector in a position between the terminals. In the example illustrated, one retaining formation of the connector 32 is a projection 36 formed on the contact element 35. A complementary depression is formed in the tail of the connector 16 to receive the projection 36. A corresponding depression is shown at 37 in the tail 23 and this depression receives a projection corresponding to the projection 36 on the opposite side of the connector 32. The connector is a snap-fit between the terminals and can be removed by exerting moderate pressure on the connector. It will be noted that, when the connector is fitted between the terminals, it extends from the level of the free edge of the limb 20 into the slot 22 at least to the level of the free edge of the tail 23 and, possibly, nearer to or up to the bottom wall 11.

The example of terminal box illustrated in Figure 1 of the drawings comprises a further pair of terminals 37, 38 which are identical with the terminals 15 and 16, which are also mounted on the seat 18 adjacent to a further slot 39 therein and are spaced along the seat from the terminals 15 and 16. For connecting the micro-switch 29 with the terminals 37 and 38, there is provided a further connector 40 which is identical with the connector 32 and a pair of flexible leads extending from the connector to the micro-switch.

Prior to assembly of the call point 25 with the terminal box 10, a link 41 is fitted between the terminals 15 and 16 to establish an electrically conductive path between these terminals. The form of the link 41 may be substantially the same as that of the block of the connector 32, except that the link 41 does not have terminations for leads. The block may be formed of a plastics material and rendered electrically conductive by the application of a surface layer of a metal.

The link 41 is a snap-fit or a force-fit between the terminals 15 and 16 and is preferably inserted between the terminals when the terminal box is manufactured. After installation of the terminal box and connection of the terminal box with a remote station by means of cables having conductors connected with the terminals 15 and 16, the installation can be tested electrically, current being conducted through the terminals 15 and 16 and the link 41. An identical link is preferably provided between the terminals 37 and 38. The links protect the conductive faces of the terminals and reduce the risk of the terminals being damaged mechanically before the call point 25 is fitted.

The link 41 occupies the gap 17 between the terminals 15 and 16 during testing of the installation, prior to fitting of the call point 25. In this position, the link obstructs application of the connector 32 to the terminals 15 and 16. In order to fit the connector to the terminals, the link 41 must be displaced completely from the terminals. The link will be removed entirely from the terminal box so that it will not subsequently be available to provide an electrically conductive path between the terminals 15 and 16. An identical link (not shown) is provided between the terminals 37 and 38.

In the event of the call point 25 being removed from the terminal box 10, the connector 32 and the connector 40 will necessarily be removed also and this will leave the terminal 16 isolated from the terminal 15 and the terminal 37 isolated from the terminal 38. This condition can be detected electrically at the remote station.

One pair of the four leads extending between the terminal box 10 and the call point 25 may be used for conducting a signal from the microswitch 29 to the cables connected with the terminal box, in the event of the microswitch operating, and the other pair of these conductors may be used for monitoring the connections to the microswitch so that a failure in the wiring from the remote station to the terminals of the microswitch can be detected. In a case where such monitoring is not required, only a single pair of conductors is required to extend from the terminal box to the call point and the terminals 37 and 38 may be omitted.

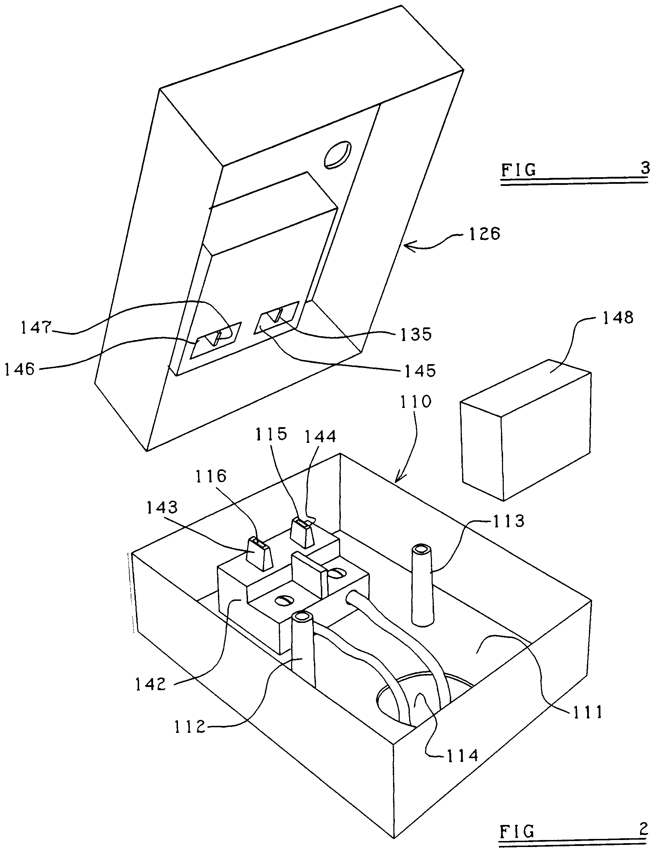

Certain parts of the terminal box illustrated in Figure 2 and of the call point illustrated in Figure 3 correspond to those hereinbefore described with reference to Figure 1. In Figures 2 and 3, such corresponding parts are identified by like reference numerals with the prefix 1 and the preceding description is deemed to apply, except for differences herein after mentioned.

The terminal box 110 has only a single pair of terminals 115 and 116. These are mounted in a terminal block 142 which is formed integrally with or which is mounted on the bottom wall 111 of the terminal box. In the example illustrated, the terminal block 142 has a pair of spaced, hollow spigots 143 and 144 and the terminals 115 and 116 lie in respective ones of these spigots so that the terminal block protects the terminals against mechanical damage.

The call point 125 has a pair of sockets 145 and 146 in a body which is mounted on or formed integrally with the housing 126. This body is formed of an electrically insulating material and the sockets contain electrically conductive contact elements 135 and 147. The spigots 143 and 144 are arranged to enter the sockets 145 and 146 respectively when the call point 125 is fitted to the terminal box 110. The contact elements 135 and 147 are arranged to engage the terminals 116 and 115 when the call point is fitted to the terminal box. Preferably, the terminals are formed to grip the corresponding contact elements of the call point. However, known forms of plug and socket connector may be provided for releasably connecting the call point electrically with the terminal box.

The call point 125 comprises fixed electrical conductors (not shown) extending from the contact elements 135 and 147 to the microswitch (not shown). The electrical connections provided by these conductors are unlikely to be disturbed, once the call point has been constructed. It is therefore unnecessary to monitor these connections from the remote station separately from monitoring of the condition of the microswitch. However, if provision for monitoring of the electrical connections up to the microswitch is required, the terminal box 110 and the call point 125 could be provided with two pairs of electrical terminals and contact elements, corresponding to those of the call point and terminal box illustrated in Figure 1.

When the terminal box 110 is manufactured, a link 148 is fitted to the terminal block 142. The link has sockets for receiving the spigots 143 and 144 and has a electrical conductor for providing an electrically conductive path between the terminals 115 and 116. The link is formed mainly of an electrically insulating material and covers the terminals 115 and 116, when fitted to the terminal block. It then projects from the terminal block 142 in such a manner that assembly of the call point 125 with the terminal box 110 is prevented. The link 148 must be removed, before the call point can be fitted.

The features disclosed in the foregoing description, or the following claims, or the accompanying drawings, expressed in their specific forms or in terms of a means for performing the disclosed function, or a method or process for attaining the disclosed result, as appropriate, may, separately or in any combination of such features, be utilised for realising the invention in diverse forms thereof.

## Claims

1. A terminal box and a call point which are suitable for releasable mounting of the call point (25, 125) on the terminal box (10, 110), wherein the terminal box includes at least one pair of electrical terminals (15, 16, 115, 116)and wherein the call point includes a signalling device, (29) a connector (32) and a pair of electrical conductors (33, 34) extending between the signalling device and the connector, the connector being adapted to cooperate with the terminals to establish a releasable, electrical connection between the signalling device and the terminals.

2. A terminal box and call point according to Claim 1 comprising a link (41) which links said terminals electrically to each other, is displaceable from the terminals and which, whilst linking the terminals, obstructs application of said connector to the terminals, whereby application of the connector to the terminals to connect the signalling device with the terminals can be achieved only by displacing the link from the terminals.

3. A terminal box and call point according to Claim 1 or according to Claim 2 wherein said terminals are spaced apart by a gap (17) and the connector (41) is of a size to fit in the gap, in engagement with both terminals.

4. A terminal box and call point according to any preceding claim which are provided with respective retaining formations which, when the connector is applied to the terminals, cooperate with each other to retain the connector in assembled relation with the terminals.

5. A terminal box and call point according to Claim 1 or Claim 2 wherein the connector is fixed with respect to the signalling device.

6. A terminal box and call point substantially as herein described with reference to Figure 1 of the accompanying drawings or substantially as herein described with reference to Figures 2 and 3 of the accompanying drawings.

7. A terminal box and call point substantially as herein described with reference to the accompanying drawing.

8. Any novel feature or novel combination of features disclosed herein or in the accompanying drawing.

FIG 1

FIG 3

126

148

147

135

146

145

110

115 144

116

113

143

142

112

111

114

FIG 2

**European Patent Office**

## EUROPEAN SEARCH REPORT

Application Number

EP 91 31 0781

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | EP-A-0 065 826 (TANN-SYNCHRONOME) * figure 3; abstract * | 1,6 | G 08 B 25/12 H 05 K 5/02 |
| Y | DE-U-7 141 337 (LICENTIA PATENT-VERWALTUNGS-GMBH) * figures 1,2; claim 1 * | 1,6 | |
| Y | DE-A-3 415 734 (JÄRNKOST) * figure 1; page 6, line 11 - page 7, line 3 * | 1,6 | |
| Y | DE-A-1 465 423 (DEUTSCHE TELEPHONWERKE U. KABELINDUSTRIE) * figures 1-3; page 5, lines 7-24 * | 1,6 | |
| P,A | WO-A-9 107 865 (ROBERT BOSCH) * figure 1; abstract * | | |
| A | US-A-4 136 919 (G.W. HOWARD et al.) * figure 3; column 3, lines 26-37 * | 4 | |
| A | US-A-2 498 743 (L. THERIAULT) * figure 7 * | | TECHNICAL FIELDS SEARCHED (Int. Cl.5) G 08 B H 05 K |

The present search report has been drawn up for all claims

| Place of search | Date of completion of the search | Examiner |
|---|---|---|
| BERLIN | 30-01-1992 | BREUSING J |